# EUROPEAN PATENT APPLICATION

(11) **EP 2 594 949 A1**
(43) Date of publication of application: **22.05.2013**
(21) Application number: 11786625.1
(22) Date of filing: 24.05.2011
(51) Int. Cl.: G01R 31/02, B60L 11/18, H02J 7/00

(54) **POWER SUPPLY DEVICE**

(30) Priority: 28.05.2010 JP 2010122607
(71) Applicant: Sanyo Electric Co., Ltd., Osaka 570-8677 (JP)
(72) Inventor: NAKAJIMA, Kaoru, Osaka 570-8677 (JP); NISHIMURA, Masato, Osaka 570-8677 (JP)
(74) Representative: Hertz, Oliver
(86) International application number: PCT/JP2011/061832
(87) International publication number: WO 2011/148926

(57) **Abstract**

[Problem to be Solved] To prevent false determination of a fuse blowout with a fuse not blown by certainly detecting the fuse blowout.

[Solution] A power supply apparatus includes: a drive battery (1) having a plurality of battery units (2) connected in series; a fuse (19) connected in series with the drive battery (1); a voltage detection circuit (3) detecting a voltage of the battery unit (2) by dividing the voltage at a resistance voltage dividing circuit (11) with a line connected to one end of the fuse (19) as a ground line; and a blowout detection circuit (4) detecting a blowout of the fuse (19) based on the voltage detected at the voltage detection circuit (3). The blowout detection circuit (4) determines that the fuse is blown when a detected voltage of the battery unit (2) connected to a fuse (19) side with respect to the ground line falls within an abnormal range. Further, in the power supply apparatus, the blowout detection circuit (4) determines that the fuse is blown when detected voltages of a plurality of battery units (2) fall within the abnormal range.

## Description

### [Technical Field]

The present invention relates to a power supply apparatus mounted on, for example, a hybrid automobile, an electric automobile, or the like for supplying electric power to a motor causing a vehicle to drive and, more particularly, to a power supply apparatus having a circuit determining whether or not a fuse connected in series with a battery is blown.

### [Background Art]

A power supply apparatus for a vehicle including a battery has a fuse connected in series with the battery. An extraordinarily large current is blocked by blowing the fuse due to an overcurrent of the battery. The fuse is blown by heat generation thereof. Therefore, like a protection circuit including an electronic circuit, it can be avoided that a current cannot be blocked due to a circuit failure or a mechanism failure, thereby being able to stably block the overcurrent of the battery.

Since the power supply apparatus for a vehicle has the fuse connected in series with the battery, electric power cannot be supplied to a motor causing the vehicle to drive when the fuse is blown. Blowing the fuse therefore leads to an inability to drive by the motor. The power supply apparatus therefore determines whether or not the fuse is blown, for example, every time an ignition switch of a main switch of the vehicle is switched on. After confirming that the fuse is blown, for example, "READY" is displayed on a monitor of the vehicle, allowing the vehicle to normally drive.

The power supply apparatus for a vehicle having a circuit detecting a fuse blowout has been developed (see Patent Literature 1).

### [Citation List]

### [Patent Literature]

Patent Literature 1: Japanese Patent Laid-Open No. 2008-86069

### [Summary of Invention]

### [Technical Problem]

A power supply apparatus disclosed in Patent Literature 1 determines whether or not a fuse is blown by detecting voltages of battery modules connected in series. In the power supply apparatus, the voltages of the battery modules are detected with one side of the fuse as a ground line. The detected voltages of the battery modules therefore change depending on whether the fuse is blown or not. Accordingly, if the detected voltage falls within a normal range, a fuse blowout cannot be determined, while if the detected voltage falls within an abnormal range, the fuse blowout can be determined.

In the above power supply apparatus, however, the detected voltage of the battery module may fall within the abnormal range due to other than the fuse blowout, for example, a contact failure of a line for detecting voltages of the battery modules. Unfortunately, the power supply apparatus determining whether or not the fuse is blown based on the detected voltage cannot certainly determine whether a failure other than the fuse blowout or a failure of the fuse occurs.

When a fuse blowout is determined, a power supply apparatus for a vehicle does not display "READY" on a monitor not allowing the vehicle to drive even after an ignition switch is switched on. It is important for vehicles not to enter a state of inability to drive if possible. This is because a state of the vehicle incapable of driving has a significantly harmful effect on a driver under certain circumstances or places and jeopardizes the safety of the driver.

The present invention has been made in order to solve the problems. An important object of the present invention is to provide a power supply apparatus preventing a false determination of a fuse blowout with a fuse not blown by certainly detecting the fuse blowout.

### [Solution to Problem and Advantageous Effects of Invention]

A power supply apparatus of the present invention includes: a drive battery 1 having a plurality of battery units 2 connected in series; a fuse 19 connected in series with the drive battery 1; a voltage detection circuit 3 detecting a voltage of the battery unit 2 by dividing the voltage at a resistance voltage dividing circuit 11 with a line connected to one end of the fuse 19 as a ground line; and a blowout detection circuit 4 detecting a blowout of the fuse 19 based on the voltage detected at the voltage detection circuit 3. The blowout detection circuit 4 determines that the fuse is blown when a detected voltage of the battery unit 2 connected to a fuse 19 side with respect to the ground line falls within an abnormal range. Further, in the power supply apparatus, the blowout detection circuit 4 determines that the fuse is blown when detected voltages of a plurality of battery units 2 fall within the abnormal range.

The above power supply apparatus certainly detects the fuse blowout, preventing false determination of the fuse blowout with the fuse not blown. The power supply apparatus does not therefore cause the vehicle to stop driving due to the false determination of the fuse blowout, allowing the vehicle to safely drive. This is because, unlike a conventional technique, the above power supply apparatus does not immediately determine that the fuse is blown when a detected voltage falls within the abnormal range but determines that the fuse is blown only when a plurality of detected voltages fall within the abnormal range.
Further, in order to prevent overcharge or overdischarge of the respective battery units connected in series, the power supply apparatus detects voltages of a plurality of battery units. A dedicated voltage detection circuit for detecting the voltages of the plurality of battery units does not need to be provided, allowing correct detection of the fuse blowout based on the detected voltages detected at the existing voltage detection circuit. Accordingly, the fuse blowout can be certainly determined with a simple circuit configuration.

According to the power supply apparatus of the present invention, the blowout detection circuit 4 can determine that the fuse is blown when voltages of two or more battery units 2 are detected, revealing that two or more detected voltages fall within the abnormal range, or when voltages of three or more and an odd number of battery units 2 are detected, revealing that the number of detected voltages in the abnormal range is more than the number of detected voltages in a normal range.
The fuse blowout can be immediately determined in the power supply apparatus where the fuse blow out is determined when voltages of two or more battery units are detected, revealing that two or more detected voltages fall within the abnormal range. This is because the fuse blowout can be determined based on two or more detected voltages. As for the power supply apparatus where the fuse blowout is determined when voltages of three or more and an odd number of battery units are detected, revealing that the number of detected voltages in the abnormal range is more than the number of detected voltages in the normal range, the fuse blowout can be more correctly determined. This is because the fuse blowout is determined when a large number of detected voltages fall within the abnormal range.

According to the power supply apparatus of the present invention, the battery unit 2 has one or more cells connected in series.

According to the power supply apparatus of the present invention, the cell of the battery unit 2 is either a lithium ion battery cell or a nickel metal hydride battery cell.

According to the power supply apparatus of the present invention, the drive battery 1 supplies electric power to a motor causing a vehicle to drive.

### [Brief Description of Drawings]

[Figure 1] Figure 1 is a schematic block diagram of a power supply apparatus for a vehicle according to an embodiment of the present invention.
[Figure 2] Figure 2 is a diagram illustrating a state of the power supply apparatus in Figure 1 where a voltage of a battery unit is measured with a fuse not blown.
[Figure 3] Figure 3 is a diagram illustrating a state of the power supply apparatus in Figure 1 where the voltage of the battery unit is measured with the fuse blown.
[Figure 4] Figure 4 is a diagram illustrating the power supply apparatus in Figure 1 with a line for detecting the voltage of the battery unit broken.
[Figure 5] Figure 5 is a block diagram illustrating an example in which a power supply apparatus is mounted on a hybrid automobile driven by an engine and a motor.
[Figure 6] Figure 6 is a block diagram illustrating an example in which a power supply apparatus is mounted on an electric automobile only driven by a motor.
[Figure 7] Figure 7 is a block diagram illustrating an example of an application to a power supply apparatus for storage of electricity.

### [Description of Embodiments]

Hereinafter, an embodiment of the present invention will be described with reference to the drawings. The embodiment described below is deemed to be merely illustrative of a power supply apparatus for giving a concrete form to the technical idea of the present invention, and therefore, the present invention is not limited to the power supply apparatus described below. Further, in the description, reference numerals corresponding to components described in the embodiment are assigned to components described in "Claims" and "Solution to Problem" for the sake of better understanding the claims. However, the reference numerals do not limit the component described in the claims to the components described in the embodiment.

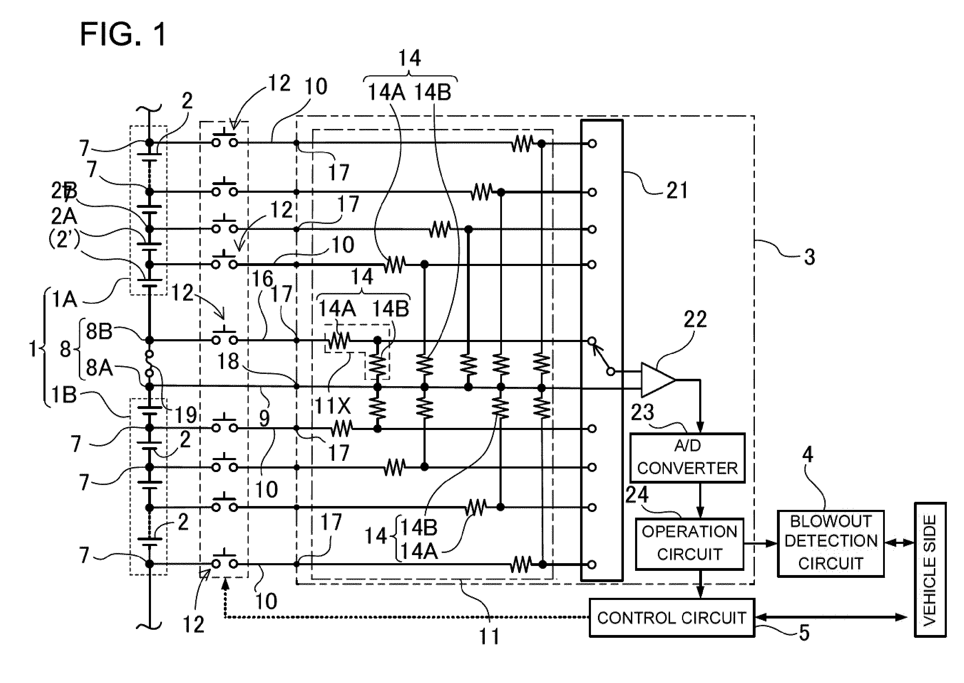

A power supply apparatus for a vehicle in Figure 1 includes: a drive battery 1 having a plurality of battery units 2 connected in series; a fuse 19 connected in series with the drive battery 1; a voltage detection circuit 3 detecting a voltage of each battery unit 2 and a voltage of the fuse 19 with a line connected to one end of the fuse 19 as a ground line, and with a connection point 8 between the fuse 19 and the battery units 2 and connection points 7 among the battery units 2 as measurement points; and a blowout detection circuit 4 detecting a blowout of the fuse 19 based on a voltage detected at the voltage detection circuit 3.

The drive battery 1 includes a battery block 1A on a positive side and a battery block 1 B on a negative side connected to each other in series via the fuse 19. The drive battery 1 in the figure has the battery block 1A on the positive side and the battery block 1 B on the negative side connected to each other at the middle connection point 8 via the fuse 19. The fuse 19 is blown to protect the drive battery 1 from an overcurrent when a current larger than a rated current flows. Each of the battery block 1 A on the positive side and the battery block 1 B on the negative side has a plurality of cells connected in series.

In the power supply apparatus in the figure, the drive battery 1 is divided into two blocks of the battery block 1 A on the positive side and the battery block 1 B on the negative side. For example, the drive battery 1 having a total of 50 battery units 2 connected in series may be divided into the battery block 1A on the positive side having 25 battery units 2 connected and the battery block 1 B on the negative side having 25 battery units 2 connected, or may be divided into two blocks each having the different number of battery units 2 and making the total of 50, like into the battery block on the positive side having 24 battery units connected and the battery block on the negative side having 26 battery units connected. The voltage detection circuit 3 detects voltages of the battery units 22 in the respective battery block 1A and battery block 1 B.

Each of the battery units 2 has one to six cells connected in series. The battery unit 2 including one cell employs a lithium ion battery cell, while the battery unit having a plurality of cells connected in series employs a nickel metal hydride battery cell. The drive battery employing a nickel metal hydride battery cell has, for example, five nickel metal hydride battery cells connected in series to obtain a battery unit. 250 of the nickel metal hydride battery cells are connected in series in total to give an output voltage of 300 V. The battery unit employing the nickel metal hydride battery cell does not necessarily have five cells connected in series, and may have four or less, or six or more cells connected in series, for example. Further, the drive battery does not necessarily have 50 battery units connected in series, and may have less than 50 or more than 50 battery units connected in series. As for the battery unit 2 of one lithium ion battery cell, a voltage of each battery unit 2 is detected to prevent overcharge and overdischarge of all the cells.

In the power supply apparatus detecting a voltage at a pair of voltage detection circuits 3 by dividing the drive battery 1 into the battery block 1A on the positive side and the battery block 1 B on the negative side, followed by connecting the battery blocks 1 A and 1 B in series, the connection points 7 and 8 of the battery unit 2 as a measurement point of a voltage are switched by a multiplexer 21 to detect a voltage at the measurement point.

The drive battery 1 in the figure has the battery block 1A and the battery block 1 B connected to the positive side and the negative side of the fuse 19, respectively. The battery block 1 A, the battery block 1 B and the fuse 19 are connected to each other at the middle connection point 8. The connection point 8 between both ends of the fuse 19 and the battery blocks 1 A and 1 B includes a first middle connection point 8A connected to the battery block 1 B on the negative side and having an electric potential of the ground line, and a second middle connection point 8B connected to the battery block 1A on the positive side. The battery units 2 in the battery block 1A on the positive side and the battery block 1 B on the negative side are connected at the middle connection point 8 via the fuse 19, thereby being connected to each other in series.

The voltage detection circuit 3 detects a voltage of each battery unit 2 for preventing overcharge and overdischarge of the battery units 2. The power supply apparatus detects the voltage of each battery unit 2 by detecting a voltage of a measurement point with the connection point 7 of each battery unit 2 as the measurement point. The voltage detection circuit 3 detects voltages of all the battery units 2 by detecting voltages of the measurement points with all the connection points 7 as the measurement points. The voltage detection circuit, however, does not necessarily detect the voltages of the measurement points of all the connection points. A plurality of battery units connected in series may be regarded as one unit, and then, a connection point between the units is regarded as a measurement point, followed by detecting a voltage of the measurement point as a voltage of the one unit including the plurality of battery units. For example, in a battery having 50 battery units 2 connected in series, it is preferred that the voltage detection circuit 3 detects voltages of all the 50 battery units 2 individually. Alternatively, voltages of 25 units may be detected by regarding two battery units as one unit and a total voltage of the two battery units as a voltage of the one unit.

The detected voltage of the battery unit 2 is used for detecting a remaining capacity of the battery unit 2 or for correcting a remaining capacity calculated by adding up charging and discharging currents. The detected voltage of the battery unit 2 is also used for blocking a discharging current under an overdischarged state by detecting the remaining capacity of 0 resulting in a full discharge, and further, for blocking a charging current under an overcharged state by detecting a full charge.

The drive battery 1 having a plurality of battery units 2 connected in series is charged and discharged with the same current. An amount of charge is therefore equal to an amount of discharge in all of the battery units 2. However, not all of the battery units 2 have the same electrical characteristics. In particular, when the number of repetitions of charging/discharging increases, the respective battery units 2 deteriorate with different degrees, leading to variation of a capacity capable of charging and discharging. In such a state, the battery unit 2 with the capacity capable of the full charge reduced is easily overcharged or overdischarged. Since the battery characteristics of the battery unit 2 significantly deteriorates due to the overcharge and overdischarge, the overcharge or overdischarge of the battery unit 2 with the capacity capable of the full charge reduced results in significant deterioration. The drive battery 1 has a large number of battery units 2 connected in series, however, the overcharge and overdischarge is prevented by detecting voltages of all the battery units 2 and controlling charging/discharging based on the detected voltages. That is, the power supply apparatus for a vehicle includes the voltage detection circuit 3 detecting voltages of the battery units 2 for performing charging/discharging with the battery units 2 protected.

The voltage detection circuit 3 detects a voltage with a line connected to one end of the fuse 19 as a ground line and with the connection point 7 with respect to the ground line as a measurement point, and calculates a voltage of each battery unit 2 based on a detected voltage difference between the measurement points. In the power supply apparatus in the figure, the first middle connection point 8A of the connection point 8 between the battery block 1 B on the negative side and the fuse 19 is connected to a reference input terminal 18 of the voltage detection circuit 3 via a reference connection line 9. The reference connection line 9 is a lead having one end connected to the first middle connection point 8A of the drive battery 1 via a terminal or a connector and having the other end connected to the reference input terminal 18 of the voltage detection circuit 3. The reference connection line 9 corresponds to the ground line of the voltage detection circuit 3. In order to prevent an electric shock, the reference connection line 9, or the ground line of the voltage detection circuit 3 is not connected to a chassis ground of the vehicle.

The connection point 7 of the battery unit 2 is connected, as a measurement point of a voltage, to a voltage input terminal 17 of the voltage detection circuit 3 via a detection switch 12 and a voltage detection line 10. The voltage detection circuit 3 detects a voltage of the connection point 7 of the measurement point with respect to the first middle connection point 8A for calculating the voltage of each battery unit 2.

Further, in the power supply apparatus in Figure 1, the second middle connection point 8B, or the other end of the fuse 19 is connected, as the measurement point of the voltage, to the voltage input terminal 17 of the voltage detection circuit 3 via a fuse-voltage detection line 16. The fuse-voltage detection line 16 detects voltages at the both ends of the fuse 19. That is, voltages of the first middle connection point 8A and the second middle connection point 8B are input to the voltage detection circuit 3 to detect the voltages at the both ends of the fuse 19. In the power supply apparatus detecting the voltages at the both ends of the fuse 19, a voltage of the battery unit 2 can be detected considering a voltage drop of the fuse 19 at the time of a current flowing through the drive battery 1, that is, causing the vehicle to drive as well as calculating the voltage of the battery 2. As for a power supply apparatus not detecting a voltage drop of a fuse, correct detection cannot be performed with respect to a voltage of a battery unit 2' on a negative side connected closest to the negative side among the battery units 2 of the battery block 1A on the positive side in Figure 1. This is because the voltage drop of the fuse 19 is added to the voltage of the battery unit 2' on the negative side. The voltage drop of the fuse 19 added to the voltage of the battery unit 2' on the negative side can be subtracted by detecting the voltage drop of the fuse 19, thereby allowing the voltage of the battery unit 2' on the negative side to be correctly detected.

In the power supply apparatus in the figure, the ground line is formed by connecting the reference connection line 9 to the first middle connection point 8A of the connection point 8 between the battery block 1 B on the negative side and the fuse 19, and the fuse-voltage detection line 16 detecting a voltage of the fuse 1 is connected to the second middle connection point 8B of the connection point 8 between the battery block 1 A on the positive side and the fuse 19. In the power supply apparatus, however, the ground line may be formed by connecting the reference connection line to the second middle connection point of the connection point between the battery block on the positive side and the fuse, and the fuse-voltage detection line may be connected to the first middle connection point of the connection point between the battery block on the negative side and the fuse. According to thus obtained power supply apparatus, by detecting the voltage drop of the fuse, correct detection can be performed with respect to a voltage of a battery unit connected closest to the positive side among the battery units of the battery block on the negative side.

The voltage detection circuit 3 includes a resistance voltage dividing circuit 11 dividing a voltage of each measurement point, the multiplexer 21 detecting the voltage divided at the resistance voltage dividing circuit 11 by time sharing, and a voltage detection portion 22 connected to an output side of the multiplexer 21.

The resistance voltage dividing circuit 11 has two resistors 14 connected in series and divides a voltage of a measurement point, followed by inputting the divided voltage to the multiplexer 21. A maximum voltage of the measurement point is higher than a maximum input voltage of the multiplexer 21. The resistance voltage dividing circuit 11 drops the voltage of the measurement point with a specific division ratio. The division ratio of the resistance voltage dividing circuit 11 is specified by electrical resistances of the resistors 14 connected in series. The division ratio of the resistance voltage dividing circuit 11 can be increased, that is, an input voltage of the multiplexer 21 can be reduced by increasing an electrical resistance of a series resistor 14A connected in series with an input of the multiplexer 21 compared with a parallel resistor 14B connected in parallel with the input of the multiplexer 21.

The resistance voltage dividing circuit 11 preferably drops a voltage of the measurement point up to a several volts to input the voltage to the multiplexer 21. A ratio in which the resistance voltage dividing circuit 11 drops the voltage of the measurement point is specified by a ratio of electrical resistances. Therefore, the detected voltage is, as described below, calculated at an operation circuit 24 through the voltage detection portion 22 and an A/D converter 23, and then is corrected to obtain an actual voltage considering the division ratio of the resistance voltage dividing circuit 11. If the division ratio of the resistance voltage dividing circuit 11 is 1/50, for example, the voltage detection circuit 3 multiplies the detected voltage by 50 to obtain a voltage of the measurement point.

The resistance voltage dividing circuit 11 is connected to respective measurement points. That is, the resistance voltage dividing circuit 11 drops voltages of all the measurement points to input the voltages to the multiplexer 21. The resistance voltage dividing circuit 11 connected to the respective measurement points is set to have a division ratio in which input voltages of the multiplexer 21 become substantially equal.

The detection switch 12 is connected to the voltage detection line 10. The measurement point is therefore connected to the voltage input terminal 17 of the voltage detection circuit 3 via the detection switch 12 and the voltage detection line 10. The power supply apparatus detects a voltage of the battery unit 2 by switching the detection switch 12 on/off. The voltages of the battery units 2 are detected with the ignition switch switched on. The detection switch 12 is therefore switched on with the ignition switch in an on state. The detection switch 12 is controlled by a control circuit 5 to be switched on/off. The voltage detection circuit 3 detects voltages of the measurement points one after another to calculate voltages of the battery units 2 based on the detected voltages with the detection switches 12 switched on.

The power supply apparatus having the detection switches 12 connected to all the voltage detection lines 10 blocks a discharge current of the drive battery 1 to the resistance voltage dividing circuit 11 when the vehicle is not in use with all of the detection switches 12 switched off, that is, the ignition switch is off.

The voltages of the battery units 2 detected at the voltage detection circuit 3 are input to the control circuit 5. The control circuit 5 calculates, based on the voltages of the battery units 2, a maximum current with which the drive battery 1 is charged/discharged, and then outputs a current control signal specifying the calculated maximum current to a vehicle side. On the vehicle side, the current with which the drive battery 1 is charged/discharged is controlled based on the current control signal input from the power supply apparatus.

Further, the power supply apparatus for a vehicle in Figure 1 outputs the detected voltage of the battery unit 2 divided at the resistance voltage dividing circuit 11 and detected at the voltage detection circuit 3 to a blowout detection circuit 4. The blowout detection circuit 4 detects a blowout of the fuse 19 based on the detected voltages of the battery units 2 connected to a fuse 19 side with respect to the ground line among the detected voltages of the battery units 2 input from the voltage detection circuit 3. As for the power supply apparatus in the figure, the reference connection line 9 is connected to the first middle connection point 8A of the connection point 8 between the battery block 1 B on the negative side and the fuse 19 for forming the ground line. The blowout of the fuse 19 is therefore detected based on the detected voltages of battery units 2 connected to the fuse 19 side with respect to the ground line, that is, the battery units 2 of the battery block 1A on the positive side. Although not illustrated in the figures, as to a power supply apparatus having the reference connection line connected to the second middle connection point of the connection point between the battery block on the positive side and the fuse for forming the ground line, a fuse blowout is detected based on the detected voltages of battery units connected to the fuse side with respect to the ground line, that is, the battery units of the battery block on the negative side.

The blowout detection circuit 4 detects voltages of two battery units 2 and determines that the fuse is blown if these detected voltages fall within an abnormal range. The blowout detection circuit 4 detecting the voltages of the two battery units 2 and determining whether or not the fuse is blown determines whether or not the fuse is blown based on a detected voltage of a first battery unit 2A, in the battery block 1A on the positive side, connected to the fuse 19 and a detected voltage of a second battery unit 2B connected to the first battery unit 2A. The blowout detection circuit 4 does not determine that the fuse is blown if either one of the detected voltages of the first battery unit 2A and the second battery unit 2B falls within the abnormal range, while determining that the fuse is blown if the detected voltages of the two battery units 2 fall within the abnormal range.

The detected voltages of the first battery unit 2A and the second battery unit 2B change depending on whether the fuse 19 is blown or not. The voltages of the battery units 2 are detected by normally dividing the voltages at the resistance voltage dividing circuit 11 with the fuse 19 not blown. On the other hand, when the fuse 19 is blown, the resistance voltage dividing circuit 11 does not normally divide the voltages, and hence the voltages of the battery units 2 are not detected normally but detected to fall within the abnormal range outside a normal range.

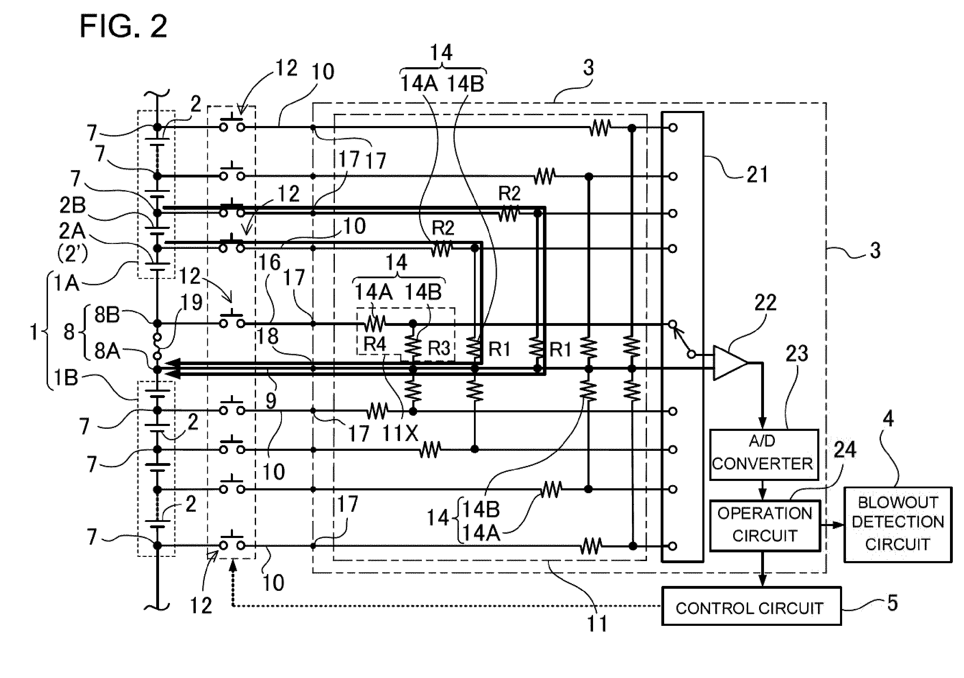

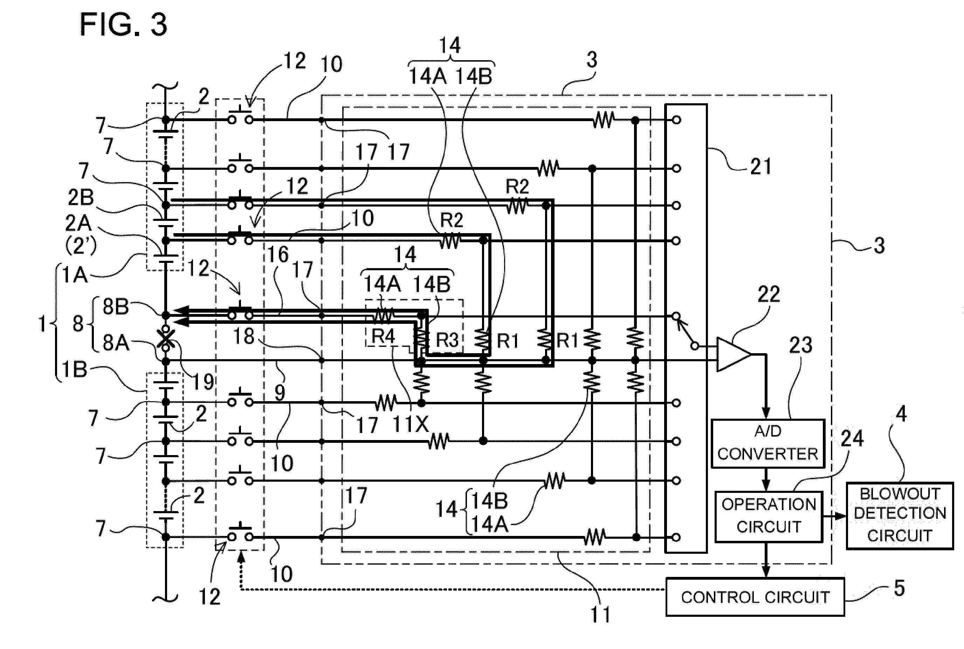

As illustrated in Figure 2, when the fuse 19 is not blown, a power supply of the battery unit 2 flows so as to loop the battery unit 2, the resistance voltage dividing circuit 11 and fuse 19, as indicated by an arrow in the figure. The voltage of the battery unit 2 is normally divided at the resistance voltage dividing circuit 11 to be input to the voltage detection circuit 3. When the fuse 19 is blown, however, the current of battery unit 2 does not flow via the fuse 19, as indicated by an arrow in Figure 3. The power supply apparatus in the figure includes a fuse-voltage dividing circuit 11X of the resistance voltage dividing circuit 11 dividing a voltage of the fuse in order to detect the voltage of the fuse 19. Therefore, when the fuse 19 is blown, the current bypasses the fuse 19 and flows via the fuse-voltage dividing circuit 11X. The fuse-voltage dividing circuit 11X has a considerably larger electrical resistance than does the fuse 19. When the fuse 19 is blown, the resistance voltage dividing circuit 11 dividing the voltage of the battery unit 2 therefore falls into a state of having the electrical resistance of the fuse-voltage dividing circuit 11X connected thereto in series. The resistance voltage dividing circuit 11 dividing the voltage of the battery unit 2 is designed with the electrical resistance of the fuse 19 substantially 0 Ω. The resistance voltage dividing circuit 11 cannot therefore divide the voltage of the battery unit 2 normally to input the voltage to the voltage detection circuit 3 when having the electrical resistance of the fuse-voltage dividing circuit 11X connected in series.

With the fuse 19 not blown in Figure 2, the resistance voltage dividing circuit 11 divides a voltage of the battery unit 2 at a series circuit including a parallel resistor 14B (R1) connected in parallel with an input side of the voltage detection circuit 3 and a series resistor 14A (R2) connected to the battery unit 2. The division ratio is R1/(R1+R2). As illustrated in Figure 3, when the fuse 19 is blown, a parallel resistor 14B (R3) and a series resistor 14A (R4) of the fuse-voltage dividing circuit 11X are further connected in series with the series circuit including the series resistor 14A (R2) connected to the battery unit 2 and the parallel resistor 14B (R1). The voltage of the battery unit 2 is divided in a division ratio of R1/(R1+R2+R3+R4) and input to the voltage detection circuit 3. The detected voltage of the battery unit 2 therefore becomes extremely low when the fuse 19 is blown, compared with the normally detected voltage.

The above blowout detection circuit 4 detects voltages of two battery units 2 and determines that the fuse is blown if these detected voltages fall within the abnormal range. The blowout detection circuit 4 may detect voltages of three or more battery units 2 to determine that the fuse is blown when the detected voltages of two or more battery units 2 fall within the abnormal range. The blowout detection circuit 4 may also detect voltages of three or more and an odd number of battery units to determine that the fuse is blown when the number of battery units whose detected voltages fall within the abnormal range is more than the number of battery units whose detected voltages fall within the normal range.

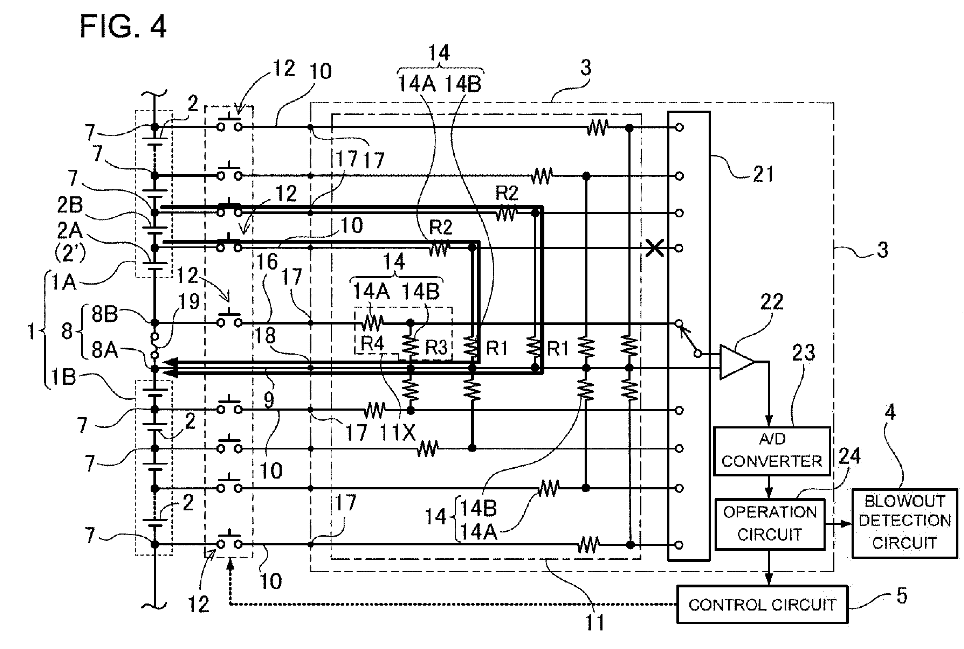

The blowout detection circuit 4 determines whether or not the detected voltages of the plurality of battery units 2 input from the voltage detection circuit 3 fall within the abnormal range for determination of the fuse blowout. All of the detected voltages of the battery units 2 fall within the abnormal range with the fuse blown. The blowout detection circuit 4 can also determine that the fuse is blown by detecting all of the detected voltages of the plurality of battery units 2 to fall within the abnormal range. The voltage detection circuit, however, cannot always detect voltages of the battery units correctly due to a contact failure of a line for detection, false detection caused by noise, or the like. As illustrated in Figure 4, for example, even if the fuse 19 is not blown, a correct voltage may not be detected due to a broken line or a contact failure of the line detecting the voltage of the battery unit 2 (indicated by a cross in the figure), or the like. Accordingly, there may be a possibility that a voltage actually supposed to be in the normal range is detected to be in the abnormal range or, on the contrary, a voltage supposed to be in the abnormal range is detected to be in the normal range. The blowout detection circuit 4 therefore detects that detected voltages of a plurality of battery units 2 are in the abnormal range, thereby determining that the fuse is blown. This is because there is a little possibility that the voltage detection circuit incorrectly detects voltages of a plurality of battery units at the same time. In particular, practically none of voltages of a plurality of the battery units actually in the abnormal range is detected to be in the normal range. Therefore, in the blowout detection circuit determining the fuse blowout based on detected voltages of two battery units, the fuse blowout is determined when the detected voltages of the two battery units are in the abnormal range. In the blowout detection circuit determining the fuse blowout based on detected voltages of three or more battery units, the fuse blowout is determined when the detected voltages of two or more battery units are in the abnormal range. This certainly enables the determination of the fuse blowout. Further, in the blowout detection circuit determining the fuse blowout based on detected voltages of three or more and an odd number of battery units, the fuse blowout may be determined when the detected voltages of two or more battery units are in the abnormal range. However, the fuse blowout can be more certainly determined by determining that the fuse is blown when the number of the battery units whose detected voltages fall within the abnormal range is more than the number of the battery units whose detected voltages fall within the normal range.

The power supply apparatus illustrated in Figures 1 to 3 has the fuse-voltage dividing circuit 11X connected in parallel with the fuse 19. As for the power supply apparatus, a current supposed to flow through the fuse 19 bypasses the fuse 19 to flow through the fuse-voltage dividing circuit 11X when the fuse 19 is blown. Voltages of the battery units 2 are therefore detected to be extremely low at the voltage detection circuit 3 due to a large division ratio, as described above. The power supply apparatus does not necessarily have the fuse-voltage dividing circuit connected in parallel with the fuse. Although not illustrated in the figure, in a power supply apparatus capable of directly detecting voltages at both ends of the fuse at the voltage detection circuit, the fuse-voltage dividing circuit does not need to be connected in parallel with the fuse. As for a power supply apparatus in which an electrical resistance of the fuse is small, and voltages at the both ends of the fuse detected as a product of the electrical resistance of the fuse and a current fall within a range capable of being detected directly at the voltage detection circuit, the voltages of the fuse can be directly detected at the voltage detection circuit without providing the fuse-voltage dividing circuit. The detected voltages of the battery units are further reduced in the power supply apparatus when the fuse is blown. This is because an electrical resistance of the resistor connected in parallel with the resistance voltage dividing circuit detecting voltages of the battery units is further increased. Therefore, according to the power supply apparatus of the present invention, a blowout of the fuse 19 can be detected based on the voltages of the battery units 2 in a circuit configuration where the fuse-voltage dividing circuit 11X is connected in parallel with the fuse 19 and also in a circuit configuration where the fuse-voltage dividing circuit is not connected in parallel with the fuse.

When the fuse blowout is detected, the power supply apparatus transmits the fact to a vehicle side. On the vehicle side, such a state does not allow the vehicle to drive by the drive battery 1, causing the vehicle to stop driving or controlling the vehicle to drive only by an engine, as to a hybrid automobile.

### (Vehicle)

As described above, the power supply apparatus can be used for a vehicle-mounted battery system. As a vehicle having a power supply apparatus mounted, electric vehicles can be utilized, for example, hybrid automobiles or plug-in hybrid automobiles driven by both an engine and a motor, or electric automobiles only driven by a motor. The power supply apparatus can be used for power supplies of these vehicles.

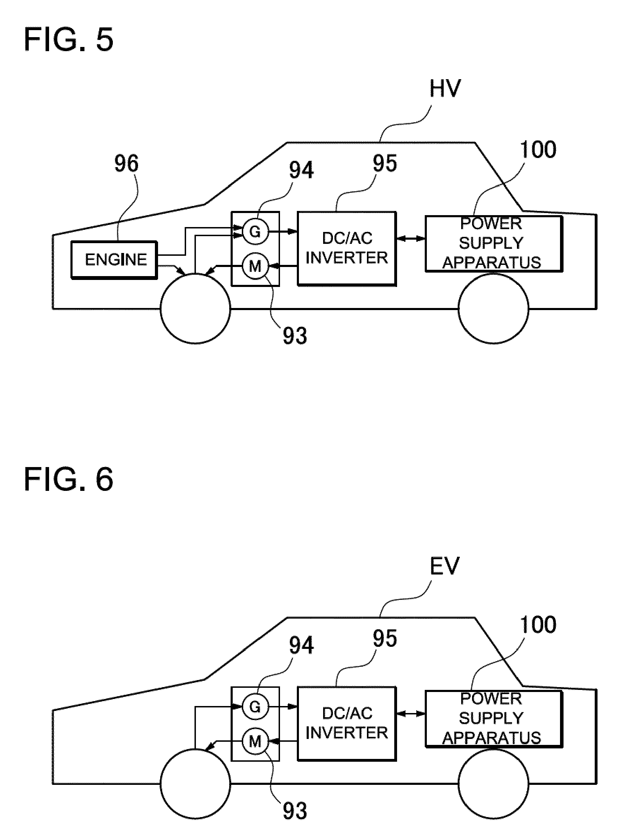

Figure 5 illustrates an example in which a power supply apparatus is mounted on a hybrid automobile driven by both an engine and a motor. A vehicle HV in the figure having a power supply apparatus mounted thereon includes an engine 96 and a drive motor 93 driving the vehicle HV, a power supply apparatus 100 supplying electric power to the motor 93, and a generator 94 charging a battery of the power supply apparatus 100. The power supply apparatus 100 is connected to the motor 93 and the generator 94 via a DC/AC inverter 95. The vehicle HV is driven by both the motor 93 and the engine 96 while the battery of the power supply apparatus 100 is charged and discharged. The motor 93 is driven in a region with low efficiency of the engine, for example, at the time of acceleration or driving at a low speed to drive the vehicle. The motor 93 is driven by having electric power supplied from the power supply apparatus 100. The generator 94 is driven by the engine 96 or regenerating braking at the time of braking the vehicle to charge the battery of the power supply apparatus 100. In the power supply apparatus 100, charging can also be performed by an external charger (not illustrated).

Figure 6 also illustrates an example in which a power supply apparatus is mounted on an electric automobile only driven by a motor. A vehicle EV in the figure having a power supply apparatus mounted thereon includes a drive motor 93 driving the vehicle EV, a power supply apparatus 100 supplying electric power to the motor 93, and a generator 94 charging a battery of the power supply apparatus 100. The motor 93 is driven by having electric power supplied from the power supply apparatus 100. The generator 94 is driven by energy at the time of regenerating braking of the vehicle EV to charge the battery of the power supply apparatus 100. In the power supply apparatus 100, charging can also be performed by an external charger (not illustrated).

### (Power Supply Apparatus for Storage of Electricity)

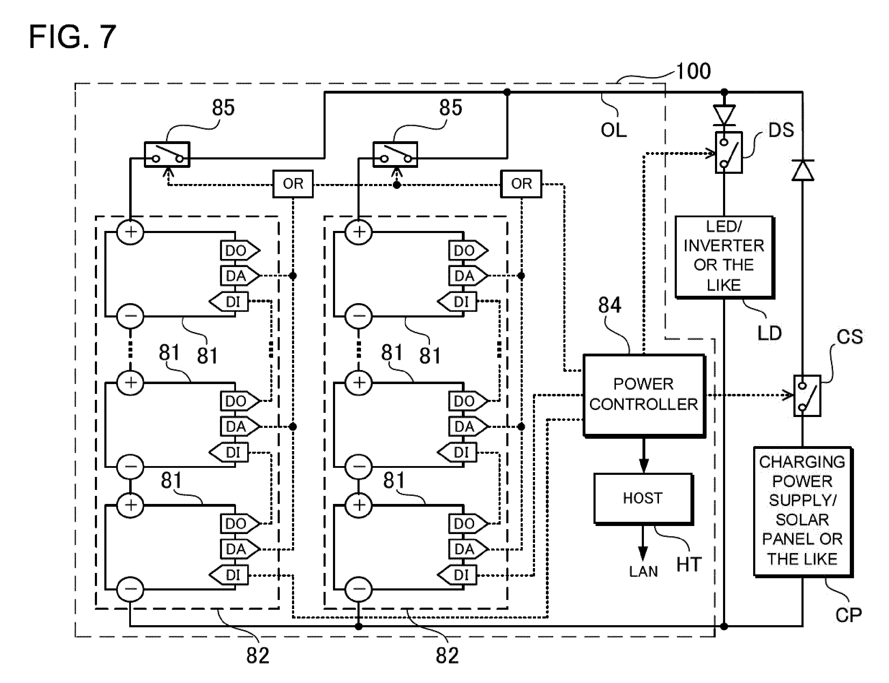

Further, the power supply apparatus can be used not only as a power source for movable bodies such as vehicles but also as installation-type equipment for storage of electricity. For example, the power supply apparatus can be used for a power supply system, as a power supply for household use or industrial use, in which charging is performed with electric power from photovoltaic power generation, night-time electric power, or the like and discharging is performed if necessary; a power supply for a streetlight performing charging with electric power from photovoltaic power generation during the daytime and performing discharging at nighttime; a backup power supply for a signal driven at the time of a power failure; or the like. Figure 7 illustrates such an example. As for a power supply apparatus 100 in the figure, a battery unit 82 is formed by connecting a plurality of battery packs 81 in a unit form. Each of the battery packs 81 has a plurality of battery cells connected in series and/or in parallel. Each of the battery packs 81 is controlled by a power controller 84. The power supply apparatus 100 causes a charging power supply CP to charge the battery unit 82 and then drives a load LD. The power supply apparatus 100 therefore includes a charging mode and a discharging mode. The load LD and the charging power supply CP are connected to the power supply apparatus 100 via a discharging switch DS and a charging switch CS, respectively. The power controller 84 of the power supply apparatus 100 switches ON/OFF of the discharging switch DS and the charging switch CS. In the charging mode, the power controller 84 switches the charging switch CS ON and the discharging switch DS OFF, permitting charging from the charging power supply CP to the power supply apparatus 100. When the charging is completed to be in a full charged condition or the charging is performed up to a capacity more than a predetermined value, according to a requirement from the load LD, the power controller 84 switches to the discharging mode by switching the charging switch CS OFF and the discharging switch DS ON, thereby permitting discharging from the power supply apparatus 100 to the load LD. Power supply to the load LD and charging to the power supply apparatus 100 can also be performed simultaneously by switching the charging switch CS ON and the discharging switch DS ON, as required.

The load LD driven by the power supply apparatus 100 is connected to the power supply apparatus 100 via the discharging switch DS. In the discharging mode of the power supply apparatus 100, the power controller 84 switches the discharging switch DS ON to connect the power supply apparatus 100 to the load LD, causing the load LD to drive by electric power from the power supply apparatus 100. A switching element such as FET can be used for the discharging switch DS. The power controller 84 of the power supply apparatus 100 controls ON/OFF of the discharging switch DS. The power controller 84 includes a communication interface for communicating with external equipment. In the example in Figure 7, the power controller 84 is connected to a host apparatus HT according to an existing communication protocol such as UART or RS-232C. A user interface for a user operation with respect to a power supply system can also be provided, as required.
Each of the battery packs 81 includes a signal terminal and a power terminal. The signal terminal includes a pack input/output terminal DI, an abnormal pack output terminal DA and a pack connection terminal DO. The pack input/output terminal DI is for inputting and outputting a signal from another pack battery or the power controller 84, while the pack connection terminal DO is for inputting and outputting a signal with respect to another pack battery of a slave pack. The abnormal pack output terminal DA is for outputting an abnormality of the pack battery to an outside. Further, the power terminal is for connecting the battery packs 81 each other in series or in parallel. The battery units 82 are connected to an output line OL via switches 85 for parallel connection to be connected to each other in parallel.

### [Reference Signs List]

| | | | |
|---|---|---|---|
| 1 | drive battery | 1A | battery block |
| | | 1B | battery block |
| 2 | battery unit | 2A | first battery unit |
| | | 2B | second battery unit |
| | | 2' | battery unit on a negative side |
| 3 | voltage detection circuit | | |
| 4 | blowout detection circuit | | |
| 5 | control circuit | | |
| 7 | connection point | | |
| 8 | connection point | 8A | first middle connection point |
| | | 8B | second middle connection point |
| 9 | reference connection line | | |
| 10 | voltage detection line | | |
| 11 | resistance voltage dividing circuit | | 11X fuse-voltage dividing circuit |
| 12 | detection switch | | |
| 14 | resistor | 14A | series resistor |
| | | 14B | parallel resistor |
| 16 | fuse-voltage detection line | | |
| 17 | voltage input terminal | | |
| 18 | reference input terminal | | |
| 19 | fuse | | |
| 21 | multiplexer | | |
| 22 | voltage detection portion | | |
| 23 | A/D converter | | |
| 24 | operation circuit | | |
| 81 | battery pack | | |
| 82 | battery unit | | |
| 84 | power controller | | |
| 85 | switch for parallel connection | | |
| 93 | motor | | |
| 94 | generator | | |
| 95 | DC/AC inverter | | |
| 96 | engine | | |
| 100 | power supply apparatus | | |
| EV,HV | vehicle | | |
| LD | load; CP charging power supply; DC discharging switch; CS charging switch | | |
| OL | output line; HT host apparatus | | |
| DI | pack input/output terminal; DA abnormal pack output terminal; DO slave pack connection terminal | | |

## Claims

1. A power supply apparatus comprising:
a drive battery (1) having a plurality of battery units (2) connected in series;
a fuse (19) connected in series with the drive battery (1);
a voltage detection circuit (3) detecting a voltage of the battery unit (2) by dividing the voltage at a resistance voltage dividing circuit (11) with a line connected to one end of the fuse (19) as a ground line; and
a blowout detection circuit (4) detecting a blowout of the fuse (19) based on the voltage detected at the voltage detection circuit (3),
wherein the blowout detection circuit (4) determines that the fuse is blown when a detected voltage of the battery unit (2) connected to a fuse (19) side with respect to the ground line falls within an abnormal range, and
wherein the blowout detection circuit (4) determines that the fuse is blown when detected voltages of a plurality of battery units (2) fall within the abnormal range.

2. The power supply apparatus according to claim 1, wherein the blowout detection circuit (4) determines that the fuse is blown when voltages of two or more battery units (2) are detected, revealing that two or more detected voltages fall within the abnormal range, or when voltages of three or more and an odd number of battery units (2) are detected, revealing that the number of detected voltages in the abnormal range is more than the number of detected voltages in a normal range.

3. The power supply apparatus according to claim 1 or 2, wherein the battery unit (2) has one or more cells connected in series.

4. The power supply apparatus according to any of claims 1 to 3, wherein the cell of the battery unit (2) is either a lithium ion battery cell or a nickel metal hydride battery cell.

5. The power supply apparatus according any of claims 1 to 4, wherein the drive battery (1) supplies electric power to a motor causing a vehicle to drive.
